Europäisches Patentamt

European Patent Office

Office européen des brevets

(19)

(11) Veröffentlichungsnummer: **0 217 147**
**B1**

(12) # EUROPÄISCHE PATENTSCHRIFT

(45) Veröffentlichungstag der Patentschrift:
**10.10.90**

(51) Int. Cl.⁵: **G01R 15/10**

(21) Anmeldenummer: **86111980.8**

(22) Anmeldetag: **29.08.86**

(54) **Schaltungsanordnung zur Ansteuerung eines Drehmagnetmessgeräts.**

(30) Priorität: **03.10.85 DE 3535252**

(43) Veröffentlichungstag der Anmeldung:
**08.04.87 Patentblatt 87/15**

(45) Bekanntmachung des Hinweises auf die Patenterteilung:
**10.10.90 Patentblatt 90/41**

(84) Benannte Vertragsstaaten:
**DE FR GB IT SE**

(56) Entgegenhaltungen:
**WO-A-82/02095**
**GB-A- 1 589 027**

(73) Patentinhaber: **VDO Adolf Schindling AG,**
**Gräfstrasse 103, D-6000 Frankfurt/Main 90(DE)**

(72) Erfinder: **Schäfer, Axel, Hauptstrasse 94, D-6232 Bad**
**Soden 2(DE)**

(74) Vertreter: **Klein, Thomas, Dipl.-Ing. (FH), Sodener**
**Strasse 9 Postfach 6140, D-6231 Schwalbach a. Ts.(DE)**

ACTORUM AG

**Beschreibung**

Die Erfindung betrifft eine Schaltungsanordnung zur Ansteuerung eines Drehmagnetmeßgeräts nach dem Oberbegriff des Anspruchs I.

Strommesser, die als Drehmagnetmeßgeräte ausgebildet sind, weisen generell einen nicht linearen Verlauf der Kennlinie, bzw. der Anzeigecharakteristik, auf. Der Verlauf kann als annähernd S-förmig definiert werden. Zur zuverlässigen und raschen Ablesung solcher Drehmagnetmeßgeräte ist jedoch im allgemeinen ein linearer Kennlinienverlauf erwünscht.

Wenn in bekannten Schaltungsanordnungen der eingangs genannten Gattung das Drehmagnetmeßgerät von einer Stromquelle gespeist wird, die durch eine Eingangsspannung - eine Meßspannung oder davon abgeleitete Spannung - gespeist wird, bleibt die angegebene nicht lineare Beziehung zwischen der Eingangsspannung und dem Zeigerausschlag des Drehmagnetmeßgeräts erhalten, wenn der Verstärker als aktiver Teil der Stromquelle mit einem ersten Gegenkopplungswiderstand und einem ersten Eingangswiderstand konventionell beschaltet ist. Der Gegenkopplungswiderstand und der erste Eingangswiderstand bilden dabei eine lineare Kennlinie der Stromquelle.

Es kann daran gedacht werden, zum Ausgleich der Nichtlinearität der Kennlinie des Drehmagnetmeßgeräts diesem Drehmagnetmeßgerät oder der Stromquelle ein nicht linear wirkendes Netzwerk, das beispielsweise mit Dioden ausgebaut ist, vorzuschalten. Solche Netzwerke sind bekannt (BG-A 1 589 027, WO-A1 82 102 095), jedoch verhältnismäßig aufwendig, wenn die Punkte wechselnder Steigung der Kennlinie exakt definiert und konstant, insbesondere temperaturunabhängig, sein sollen. Dadurch sind die Anwendungsmöglichkeiten solcher Netzwerke insbesondere für den Kraftfahrzeugarmaturenbereich beschränkt.

Der vorliegenden Erfindung liegt daher die Aufgabe zugrunde, eine Schaltungsanordnung zur Ansteuerung eines Drehmagnetmeßgeräts der eingangs genannten Gattung so weiterzubilden, daß zur Linearisierung der annähernd S-förmigen Kennlinie des Drehmagnetmeßgeräts durch eine mit drei Geraden wechselnder Steilheit angenäherte Kennlinie der gesteuerten Stromquelle die Umschaltpunkte zwischen den drei Geraden sowie deren Steigungen mit verhältnismäßig geringem Aufwand exakt und zeitbeständig festgelegt werden können.

Diese Aufgabe wird durch die in dem kennzeichnenden Teil des Anspruchs 1 angegebene Erfindung gelöst.

Diese Zusatzschaltung zu der gesteuerten Stromquelle mit einem zweiten Verstärker wirkt für einzelne Kennlinienabschnitte bzw. Geraden als Klammerschaltung an einem Eingang des ersten Verstärkers der gesteuerten Stromquelle und für einen dazwischenliegenden Kennlinienabschnitt bzw. eine mittlere Gerade als zusätzliche Gegenkopplung. Die Umschaltpunkte zwischen den Kennlinienabschnitten bzw. Geraden ebenso wie die Steigungen der Geraden wird durch die Wahl von ohm'schen Widerständen bestimmt, während die Eigenschaften der für den zweiten Verstärker und die gesteuerte Halbleiterstrecke verwendeten Halbleiter unkritisch sind. Abgesehen davon erfordert die Zusatzschaltung zu der gesteuerten Stromquelle nur wenige zusätzliche Bauelemente.

Als erster und zweiter Verstärker werden zweckmäßig Differenzverstärker verwendet, in die die variable Eingangsspannung bzw. Meßspannung entkoppelt von den Gegenkopplungsspannungen bzw. Klammerspannungen eingespeist werden kann.

Die Eingangsspannung des zweiten Verstärkers kann identisch mit der Eingangsspannung des ersten Verstärkers sein oder eine von der Eingangsspannung des ersten Verstärkers abgeleitete Spannung, beispielsweise von dem Ausgang der gesteuerten Stromquelle, darstellen.

Die gesteuerte Halbleiterstrecke, über welche der zweite Verstärker in den Gegenkopplungszweig an einem der Eingänge des ersten Verstärkers eingreift, besteht zweckmäßig aus der Kollektor-Emitterstrecke eines npn-Transistors, dessen Dimensionierung unkritisch ist.

Die Erfindung wird im folgenden anhand einer Zeichnung mit zwei Figuren näher erläutert. Es zeigen:

Fig. I ein Ausführungsbeispiel einer Schaltungsanordnung zur Ansteuerung eines Drehmagnetmeßgeräts und

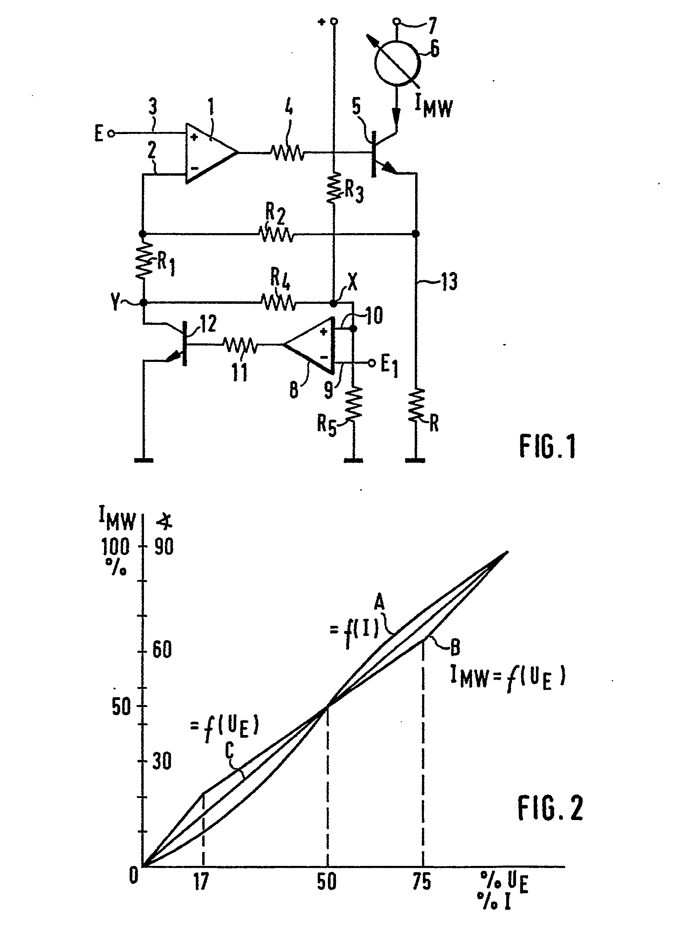

Fig. 2 zugehörige Kennlinien.

In Fig. I ist mit I ein erster Differenzverstärker bezeichnet, der einen invertierenden Eingang 2 und einen nicht invertierenden Eingang 3 aufweist, und dessen Ausgang über einen Kopplungswiderstand 4 an eine Basis eines npn-Transistors 5 angeschlossen ist. In Reihe zu der Kollektor-Emitterstrecke des npn-Transistors 5 liegen ein Drehmagnetmeßgerät 6 sowie ein Arbeitswiderstand R. An den invertierenden Eingang 2 sind ein erster verhältnismäßig hochohmiger Vorwiderstand $R_1$ sowie ein erster Gegenkopplungswiderstand $R_2$, der zu der Kollektor-Emitterstrecke des npn-Transistors 5 geführt ist, angeschlossen. Eine Eingangsspannung - Meßspannung - kann an eine Klemme E gelegt werden, die in den nicht invertierenden Eingang 3 eingespeist wird und deren Größe durch das Drehmagnetmeßgerät angezeigt werden soll.

Unter der Voraussetzung, daß der erste Vorwiderstand $R_1$ auf Massepotential liegt, kann der bisher beschriebene Schaltungsteil als konventionelle gesteuerte Stromquelle betrachtet werden, die mit der Kollektor-Emitterstrecke des npn-Transistors 5 unabhängig von Schwankungen einer Betriebsspannung an einer Klemme 7 sowie bei unterschiedlichen Innenwiderständen des Drehmagnetmeßgeräts einen der Eingangsspannung an der Klemme 7 proportionalen Strom erzeugt. Bei geeigneter Dimensionierung des ersten Differenzverstärkers können dazu die Widerstände $R_1$ und $R_2$ entfallen, d.h. letztere durch eine kurzschließende Gegenkopplungsleitung ersetzt sein.

Da insoweit die gesteuerte Stromquelle eine lineare Charakteristik hat, verläuft die Anzeige - Zeigerausschlag - des Drehmagnetmeßgeräts entsprechend der annähernd S-förmigen Kennlinie des Drehmagnetmeßgeräts in Abhängigkeit von der Eingangsspannung nicht linear.

Um gleichwohl einen linearen Zusammenhang zwischen der Anzeige des Drehmagnetmeßgeräts 6 und der Eingangsspannung an der Klemme E zu erreichen, ist die Schaltungsanordnung wie folgt erweitert:

Ein zweiter Differenzverstärker 8 mit einem invertierenden Eingang 9 und einem nicht invertierenden Eingang l0 steht über einen weiteren Kopplungswiderstand ll mit einer Basis eines zweiten npn-Transistors in Verbindung, dessen Kollektor-Emitterstrecke in Reihe zu dem ersten Vorwiderstand $R_1$ geschaltet ist. Der Emitter liegt auf Massepotential. Von der gemeinsamen Verbindungsstelle des ersten Vorwiderstands $R_1$ und dem Kollektor ist ein Gegenkopplungszweig mit einem zweiten Gegenkopplungswiderstand $R_4$ zu dem nicht invertierenden Eingang l0 des zweiten Differenzverstärkers 8 zurückgeführt. Außerdem liegt an dem nicht invertierenden Eingang l0, wie in Fig. l dargestellt, ein Konstantspannungsteiler, der aus den Teilerwiderständen $R_3$ und $R_5$ besteht. Der invertierende Eingang 9 kann über eine Eingangsklemme $E_1$ mit einer Eingangsspannung beaufschlagt werden, die identisch mit der Eingangsspannung an der Eingangsklemme E ist - dieser Betriebsfall wird im folgenden angenommen - oder von dem Ausgangspotential auf der Ausgangsleitung l3 der gesteuerten Stromquelle abgeleitet ist.

In Fig. 2 ist eine übliche Anzeigecharakteristik des Drehmagnetmeßgeräts in Abhängigkeit von einem durchfließenden Strom I mit dem Kurvenzug A dargestellt. Eine die Nichtlinearitäten des Kurvenzugs A ausgleichende Charakteristik der Schaltungsanordnung, die einen Strom $I_{MW}$ in Abhängigkeit von einer Eingangsspannung $U_E$ erzeugt, ist als Kurvenzug B angegeben. Daraus resultiert eine linearisierte Anzeige C des Drehmagnetmeßgeräts in Abhängigkeit von der Eingangsspannung $U_E$.

Im folgenden wird die Wirkung des Teils der Schaltungsanordnung besprochen, welcher die nicht lineare Charakteristik entsprechend dem Kurvenzug B erzeugt:

Bei sehr kleinen Eingangsspannungen $U_E$ an der Eingangsklemme $E_1$ überwiegt die mit dem Konstantspannungsteiler $R_3$ und $R_5$ geteilte Konstantspannung an dem nicht invertierenden Eingang l0 des zweiten Differenzverstärkers, so daß die Kollektor-Emitterstrecke des zweiten npn-Transistors l2 in den leitenden Zustand geschaltet wird und den ersten Vorwiderstand $R_1$ auf Massepotential legt. In dem Gegenkopplungszweig der gesteuerten Stromquelle mit dem ersten Differenzverstärker l und dem ersten npn-Transistor 5 sind in diesem Fall die Widerstände $R_1$ und $R_2$ wirksam, die eine verhältnismäßig hohe Steilheit entsprechend folgender Beziehung bestimmen:

$$\triangle \ \frac{I_{MW}}{\triangle \ U_E} \ = \ \frac{1 + \dfrac{R_2}{R_1}}{R}$$

Darin ist $I_{MW}$ der Ausgangsstrom der gesteuerten Stromquelle, der durch das Drehmagnetmeßgerät fließt.

Mit dieser Steilheit arbeitet die Stromquelle bis zu einer Höhe der Eingangsspannung $U_E$ gleich der geteilten Konstantspannung zwischen dem Punkt X und Massepotential.

Von diesem Wert der Eingangsspannung $U_E$ ab wirkt der Differenzverstärker 8 zusammen mit dem npn-Transistor l2 als Verstärker mit folgendem Verstärkungsfaktor V:

$$V \ = \ \frac{\triangle \ U_Y}{\triangle \ E} \ = \ 1 + \frac{R_4}{R_3 /\!/ R_5}$$

Darin ist $U_Y$ die Spannung zwischen dem aus Fig. l ersichtlichen Punkt Y und dem Massepotential. Die statt Massepotential an dem ersten Vorwiderstand $R_1$ liegende Spannung $U_Y$ bewirkt an dem invertierenden Eingang 2 des ersten Differenzverstärkers l eine Herabsetzung der Steilheit der Stromquelle nach Maßgabe des Verstärkungsfaktors V. Die Steigung des mittleren Abschnitts des Kurvenzugs B kann somit durch den Verstärkungsfaktor V bestimmt werden. In dem letztgenannten Betriebsbereich der Schaltungsanordnung kann die Spannung $U_Y$ maximal gleich der geteilten Konstantspannung an dem Punkt X werden, da die Widerstandswerte des zweiten Gegenkopplungswiderstands $R_4$ und des Konstantspannungsteilers mit den Teilerwiderständen $R_3$ und $R_5$ klein sind gegenüber demjenigen des ersten Eingangswiderstands $R_1$.

Wenn also die Eingangsspannung an der Eingangsklemme $E_1$ die geteilte Konstantspannung überschreitet, beeinflussen der zweite Differenzverstärker 8 und der zweite npn-Transistor l2 die Spannung $U_Y$ nicht mehr. In dem Gegenkopplungszweig der Stromquelle sind wiederum nur noch der erste Gegenkopplungswiderstand $R_2$ und der erste Vorwiderstand $R_1$ wirksam, die einen Spannungsteiler bilden, welcher durch die Teilerwiderstände $R_3$ und $R_5$ festgeklemmt ist. Dieses Potential bestimmt den zweiten Knickpunkt des Kurvenzugs B etwa bei 75 % $U_E$ . - Der erste Knickpunkt des Kurvenzugs B bei l7 % $U_E$ war, wie oben beschrieben, dadurch bestimmt, daß das Potential an der Eingangsklemme $E_1$ das geteilte Konstantspannungspotential an dem Punkt X erreicht.

Durch Dimensionierung der Teilerwiderstände $R_3$ und $R_5$ sowie des zweiten Gegenkopplungswiderstands $R_4$ können die beiden Knickpunkte und das Verhältnis der Steilheiten der Schaltungsanordnung einerseits in dem ersten und dritten Abschnitts des Kurvenzugs B zu dem mittleren Abschnitt dieses Kurvenzugs bestimmt werden.

**Patentansprüche**

1. Schaltungsanordnung zur Ansteuerung eines Drehmagnetmeßgeräts (6) mit einer Eingangsspannung über eine gesteuerte Stromquelle, die einen ersten Differenzverstärker (1) umfaßt, dessen invertierender Eingang mit einem ersten Gegenkopplungswiderstand (R2) und einem ersten Eingangswiderstand (R1) verbunden ist und an dessen nicht invertierendem Eingang die Eingangsspannung anliegt, dadurch gekennzeichnet, daß zur Linearisierung einer annähernd S-förmigen Kennlinie des Drehmagnetmeßgeräts (6) durch eine mit drei Geraden wechselnder Steilheit angenäherte Kennlinie (B) der gesteuerten Stromquelle ein zweiter, in Abhängigkeit von der Eingangsspannung gesteuerter Differenzverstärker (8) vorgesehen ist, dessen nichtinvertierender Eingang mit dem Teilungspunkt (X) eines Konstantspannungsteilers aus zwei Teilerwiderständen (R3, R5) sowie über einen zweiten Gegenkopplungswiderstand (R4) mit dem Verbindungspunkt (Y) einer gesteuerten Transistorstrecke (12) und des ersten Eingangswiderstandes (R1) verbunden ist, wobei das vom Verbindungspunkt (Y) abgewandte Ende der gesteuerten Transistorstrecke (12) an festem Potential liegt und dessen invertierender Eingang (9) mit der Eingangsspannung beaufschlagbar ist, und daß die Widerstandswerte des zweiten Gegenkopplungswiderstandes (R4) und der Widerstände (R3, R5) des Konstantspannungsteilers klein gegenüber demjenigen des ersten Eingangswiderstandes (R1) sind.

2. Schaltungsanordnung nach Anspruch 1, dadurch gekennzeichnet, daß der invertierende Eingang (9) des zweiten Differenzverstärkers (8) wahlweise mit dem mit der Eingangsspannung beaufschlagten Eingang (3) des ersten Differenzverstärkers (1) oder mit einem Ausgang (13) der gesteuerten Stromquelle in Verbindung bringbar ist.

**Claims**

1. Circuit arrangement for operating a moving-magnet measuring instrument (6) with an input voltage via a controlled current source, which comprises a first differential amplifier (1) whose inverting input is connected to a first negative-feedback resistor (R2) and a first input resistor (R1), and at whose non-invertig input the input voltage is present, characterised in that to linearise an approximately S-shaped characteristic of the moving-magnet measuring instrument (6) by a characteristic (B) of the controlled current source which is approximated with three straight lines of varying steepness, a second differential amplifier (8) is provided which is controlled in dependence on the input voltage and whose non-inverting input is connected to the division point (X) of a constant-voltage divider comprising two divider resistors (R3, R5), and also via a second negative-feedback resistor (R4) to the junction point (Y) of a controlled transistor path (12) and the first input resistor (R1), that end of the controlled transistor path (12) which is remote from the junction point (Y) being connected to fixed potential, and whose inverting input (9) can be supplied with the input voltage, and that the resistance values of the second negative feedback resistor (R4) and of the resistors (R3, R5) of the constant-voltage divider are small compared to that of the first input resistor (R1).

2. Circuit arrangement according to claim 1, characterised in that the inverting input (9) of the second differential amplifier (8) is connectable selectively to the input (3) of the first differential amplifier (1) to which the input voltage is applied or to an output (13) of the controlled current source.

**Revendications**

1. Disposition ou agencement de circuit, destiné(e) à commander un appareil (6) de mesure à électroaimant tournant, au moyen d'une tension d'entrée, par l'intermédiaire d'une source de courant commandée, cet agencement comprenant un premier amplificateur différentiel (1) dont l'entrée avec inversion est reliée à une première résistance (R2) de contre-réaction, ainsi qu'une première résistance d'entrée (R1); et à l'entrée sans inversion duquel est appliquée la tension d'entrée, agencement caractérisé en ce qu'en vue de rendre linéaire une courbe caractéristique, ayant approximativement une forme en S, de l'appareil (6) de mesure à électro-aimant tournant au moyen d'une courbe caractéristique (B) de la source de courant commandée, cette courbe comportant approximativement trois droites de pente différente ou alternée, on prévoit un(deuxième) amplificateur différentiel (8), commandé en fonction de la tension d'entrée, dont l'entrée sans inversion est reliée au point (X) de division d'un diviseur de tension constante, composé de deux résistances partielles (R3, R5), ainsi que par l'intermédiaire d'une deuxième résistance (R4) de contre-réaction, au point (Y) de liaison d'une partie (12) de transistor pilotée et de la première résistance (R1) d'entrée, l'extrémité de la partie pilotée (12) de transistor située à l'opposé du point de liaison (Y) étant à un potentiel fixe et son entrée (9) avec inversion pouvant recevoir la tension d'entrée, et par le fait que les valeurs de résistance de la deuxième résistance (R4) de contre-réaction et des résistances (R3, R5) du diviseur de tension constante sont faibles par rapport à celle de la première résistance d'entrée (R1).

2. Agencement de circuit selon la revendication 1, caractérisé en ce que l'entrée (9), avec inversion, du deuxième amplificateur (8) différentiel peut être reliée au choix, à l'entrée (3) soumise à la tension d'entrée du premier amplificateur différentiel (1) ou à une sortie (13) de la source de courant pilotée.

FIG.1

FIG.2